# EUROPEAN PATENT APPLICATION

(11) **EP 4 546 597 A1**
(43) Date of publication of application: **30.04.2025**
(21) Application number: 23206279.4
(22) Date of filing: 26.10.2023
(51) Int. Cl.: H02J 7/00, B60L 53/16, B60L 53/18, H01R 13/60

(54) **HOLDER FOR A CHARGING GUN AND CHARGING DEVICE WITH A HOLDER FOR A CHARGING GUN**

(71) Applicant: ABB E-mobility B.V., 2629 JG Delft (NL)
(72) Inventor: Cieciorko, Marcin, 31-038 Kraków (PL)
(74) Representative: van Trier, Norbertus Henricus Gerardus

(57) **Abstract**

The present invention relates to a holder for a charging gun, in particular to CCS or CCS-2 charging gun type, and to a device with a holder for a charging gun.

The invention relates to a holder for a charging gun, comprising:
- a housing (1) configured for receiving an end portion (7) of a charging gun (2), preferably CCS or CCS-2 type such that connector pins located at the end portion (7) of the charging gun (2) are totally covered by the housing (1) of the holder,
- a protecting means (3), configured for holding the charging gun (2) in a designated position,
- a connecting means (4) that is configured for attaching the housing (1) to a cable (5).

The subject of the invention is also a device with a charging gun (2) and a cable (5) comprising a holder

## Description

### Technical Field

The present invention relates to a holder for a charging gun, in particular to CCS or CCS-2 charging gun type, and to a device with a holder for a charging gun.

### Background

In application such as bus depos, tracks parking's, cars parking's or garage's, where the CCS or CCS-2 distribution box is mounted height above the ground (up to 6 m) and the charging cable with the charging gun freely hang out to the ground. There is a need to protect and service the charging gun. The plug mounted at the end of the charging gun has no cover therefore the connector pins are exposed to external environment conditions such as dust, water drops and moisture. Also in the situation where the cable is longer than the distance from distribution box to the ground, the cable will simple lie on the ground. Therefore there is need to protect the connector pins from external conditions and to service of the excess of the cable.

### Brief description of the invention

According to a first example of the disclosure a holder for a charging gun, comprising:
- a housing configured for receiving an end portion of a charging gun, preferably CCS or CCS-2 type such that connector pins located at the end portion of the charging gun are totally covered by the housing of the holder,
- a protecting means, configured for holding the charging gun in a designated position,
- a connecting means that is configured for attaching the housing to a cable.

Preferably, the protecting means is in a form of a blocking pin with a handle, wherein the handle is located on the outer side of the housing.

Preferably, the housing is configured for receiving the charging gun in the housing by press-fitting.

Preferably, the protecting means is in a form of a hook attached to the housing, configured for engaging the hook with a corresponding protrusion on the surface of the charging gun.

Preferably, the housing is made of a non-conductive material.

Preferably, the housing is made of a polymer.

Preferably, the holder is inclined relative to the cable at an angle of less than 90°.

Preferably, the holder comprises an adapter configured for aligning the position of the charging gun inside the housing.

Preferably, the adapter is in form of a grid.

Preferably, the connecting means is in the form of an element configured for attaching it to the housing in such a way that it is rigidly attached to the cable.

According to a second example of the disclosure a device with a charging gun and a cable comprising a holder.

### Brief Description of the Drawings

Preferred embodiment of the present invention are presented in a more detailed way with reference to the attached drawing, in which:
Figure 1 shows a holder,
Figure 2 shows a part of a device with a cable comprising a holder for the charging gun.

### Detailed Description

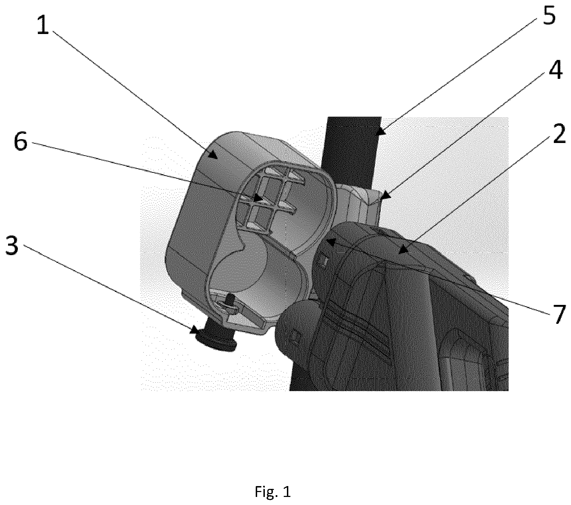

A holder for a charging gun is presented in details in Fig. 1. It comprises a housing 1 configured for receiving an end portion 7 of a charging gun 2, preferably CCS or CCS-2 type, such that connector pins located at the end portion 7 of the charging gun 2 are totally covered by the housing 1 of the holder. Such housing 1 enables protection of connector pins from environment conditions such as dust, water drops and moisture.

The holder also comprises a protecting means 3, configured for holding the charging gun 2 in a designated position. Such protecting means 3 prevents charging gun from being accidentally pulled out from the housing 1.

Moreover, the holder comprises a connecting means 4 that is configured for attaching the housing 1 to a cable 5. The holder can be thus stably connected to the cable at a desired height, preferably up to 6m.

According to the first embodiment of the invention, the protecting means 3 is in a form of a blocking pin with a handle, wherein the handle is located on the outer side of the housing 1. Holding the charging gun in one hand and the handle of blocking pin in other we are shifting the charging gun into to the housing of the gun holder. By releasing the handle of blocking pin the position of charging gun will be fixed. The blocking pin jumps to the hole in the CCS (CCS-2) plug slot.

According to the second embodiment, the housing 1 is configured for receiving the charging gun 2 in the housing 1 by press-fitting. This ensures tight and stable placement of the charging gun 2 in the holder

According to the third aspect of the invention, the protecting means 3 is in a form of a hook attached to the housing 1, configured for engaging the hook with a corresponding protrusion on the surface of the charging gun 2.

Preferably the housing 1 is made of a non-conductive material. This increases safety of the users and people gathered around the holder and also increases safety of the place in which the charging station is mounted.

Preferably, the housing 1 is made of a polymer.

Preferably, the holder is inclined relative to the cable 5 at an angle of less than 90°. This causes, that the water from the rain or any other pollutions do not stay on the surface of the housing 1 but drops to the ground.

Preferably, it comprises an adapter 6 configured for aligning the position of the charging gun 2 inside the housing 1. This causes that the charging gun 2 is stronger placed inside the housing 2. This solves the problem of empty space between the housing 1 and one part of the end portion 7 of the charging gun 2 that is shorter than the other.

Preferably the adapter 6 is in form of a grid however the person skilled in the art will know that it may be in any other shape that solves this problem.

Preferably, the connecting means 4 is in the form of an element configured for attaching it to the housing 1 in such a way that it is attached to the cable 5, preferably it is fixedly attached to the cable 5. This connection can be formed by tightening the connecting means 4 to the housing 1 by screws, by glue or in any other possible way that is known for the person skilled in the art.

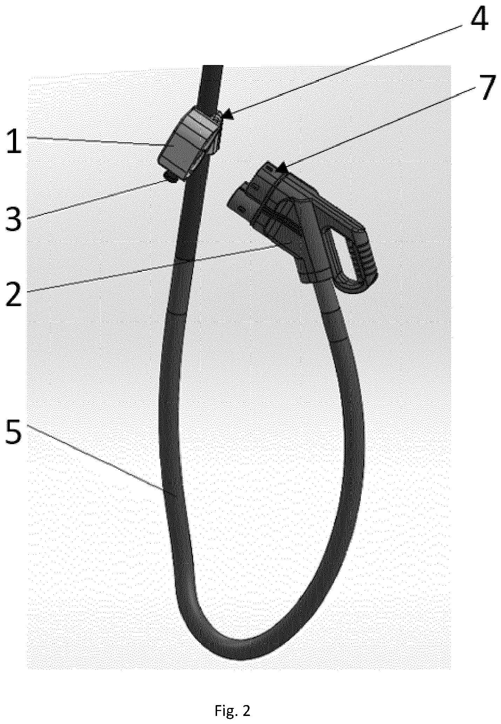

In a second example a device with a charging gun 2 and a cable 5 connected to the charging unit is disclosed. The cable 5 comprising a holder according to the invention is shown in details in Fig. 2. The holder is attached to the cable 5 as previously described.

Such device solves the problem of a need to service the excess of the cable 5, because the holder is mounted directly on the cable 5. The excess of the cable will not lie on the ground what improve safety of the crossing by people and is less vulnerable for any kind of damages which may occur while the cable 5 and/or the charging gun 2 is laying on a ground.

## Claims

1. A holder for a charging gun, comprising:
- a housing (1) configured for receiving an end portion (7) of a charging gun (2), preferably CCS or CCS-2 type such that connector pins located at the end portion (7) of the charging gun (2) are totally covered by the housing (1) of the holder,
- a protecting means (3), configured for holding the charging gun (2) in a designated position,
- a connecting means (4) that is configured for attaching the housing (1) to a cable (5).

2. The holder, according to claim 1, **characterised in that** the protecting means (3) is in a form of a blocking pin with a handle, wherein the handle is located on the outer side of the housing (1).

3. The holder, according to claim 1, **characterised in that** the housing (1) is configured for receiving the charging gun (2) in the housing (1) by press-fitting.

4. The holder, according to claim 1, **characterised in that** the protecting means (3) is in a form of a hook attached to the housing (1), configured for engaging the hook with a corresponding protrusion on the surface of the charging gun (2).

5. The holder, according to any one of the preceeding claims, **characterised in that** the housing (1) is made of a non-conductive material.

6. The holder, according to any one of the preceeding claims, **characterised in that** the housing (1) is made of a polymer.

7. The holder, according to any one of the claims 1-6, **characterised in that** it is inclined relative to the cable (5) at an angle of less than 90°.

8. The holder, according to any one of the claims 1-7, **characterised in that** it comprises an adapter (6) configured for aligning the position of the charging gun (2) inside the housing (1).

9. The holder, according to claim 8, **characterised in that** the adapter (6) is in form of a grid.

10. The holder, according to any one of the claims 1-9, **characterised in that** the connecting means (4) is in the form of an element configured for attaching it to the housing (1) in such a way that it is rigidly attached to the cable (5).

11. A charging device with a charging gun (2) and a cable (5) connected to the charging unit, wherein the cable (5) comprising a holder according to any one of the preceding claims.
